(19) Europäisches Patentamt
European Patent Office
Office européen des brevets

(11) **EP 3 902 138 A1**

(12) **EUROPEAN PATENT APPLICATION**
published in accordance with Art. 153(4) EPC

(43) Date of publication:
27.10.2021 Bulletin 2021/43

(51) Int Cl.:
*H03H 9/54* (2006.01)    *H03H 9/205* (2006.01)

(21) Application number: 19897594.8

(86) International application number:
PCT/CN2019/121083

(22) Date of filing: 26.11.2019

(87) International publication number:
WO 2020/125352 (25.06.2020 Gazette 2020/26)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
KH MA MD TN

(30) Priority: 18.12.2018 CN 201811551324

(71) Applicants:
• Tianjin University
Tianjin 300072 (CN)

• Rofs Microsystem (Tianjin) Co., Ltd
Tianjin 300462 (CN)

(72) Inventors:
• ZHANG, Menglun
Tianjin 300072 (CN)
• PANG, Wei
Tianjin 300072 (CN)
• YANG, Qingrui
Tianjin 300072 (CN)

(74) Representative: Bandpay & Greuter
30, rue Notre-Dame des Victoires
75002 Paris (FR)

(54) **RESONATOR WITH EFFECTIVE AREA REDUCED BASED ON ELEMENT DOPING, FILTER AND ELECTRONIC DEVICE**

(57) The present disclosure relates to a method for reducing the area of a resonator. The impedance value of the resonator is predetermined, the resonator has a sandwich structure composed of a bottom electrode, a piezoelectric layer and a top electrode, and the method includes the step of doping elements in the piezoelectric layer to reduce the area of the effective region. The present disclosure further relates to a bulk acoustic resonator with a predetermined impedance value, including a sandwich structure composed of a bottom electrode, a piezoelectric layer and a top electrode, wherein the piezoelectric layer is doped with elements; and the area of the resonator is not greater than 80% of the area of a reference resonator, and the reference resonator is a resonator, which has the same structure as the resonator, has the predetermined impedance value, and the piezoelectric layer of which is not doped with elements. The present disclosure further relates to a filter and electronic equipment having the filter.

Fig. 6

EP 3 902 138 A1

**Description**

**Technical Field**

Embodiments of the present disclosure relate to the field of semiconductors, in particular to a resonator, a filter unit, a method for reducing the area of a resonator, a filter having the resonator or the filter unit, and electronic equipment having the resonator or the filter.

**Background Art**

A film bulk acoustic resonator made by the longitudinal resonance of a piezoelectric film in the thickness direction has become a feasible alternative to surface acoustic wave devices and quartz crystal resonators in terms of mobile phone communication, high-speed serial data applications and other aspects.

A radio frequency front end bulk acoustic wave filter/duplexer having the film bulk acoustic resonator provides superior filtering characteristics, such as low insertion loss, steep transition band, higher power capacity, and stronger electrostatic discharge (ESD) resistance. A high-frequency film bulk acoustic resonator with ultra-low frequency temperature drift has low phase noise, low power consumption and a large bandwidth modulation range. In addition, these miniature film resonators use CMOS-compatible processing technology on silicon substrates, which can reduce the unit cost and facilitate the final integration with CMOS circuits.

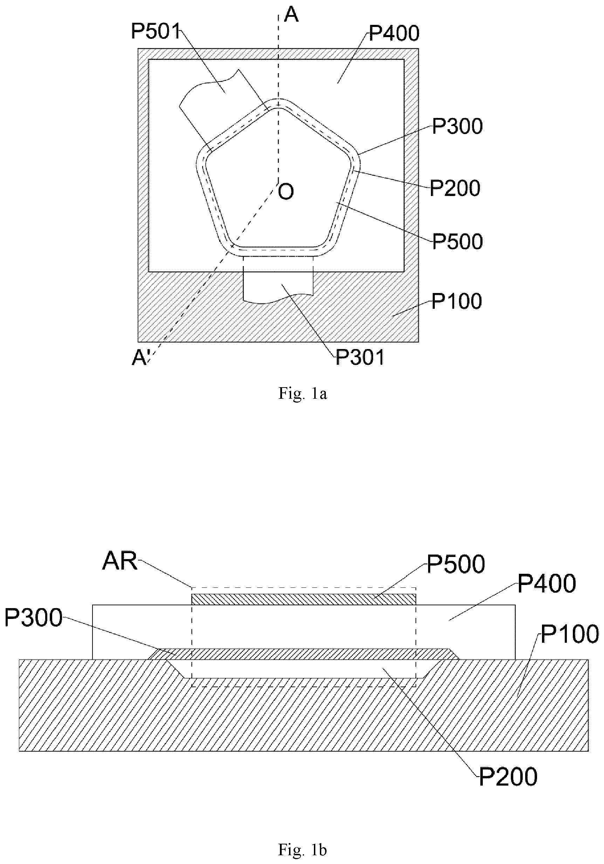

The traditional structure of the bulk acoustic resonator is shown in Fig. 1A and Fig. 1B, wherein Fig. 1B is obtained by cutting the Fig. 1A along the broken line AOA'.

As shown in Fig. 1A and Fig. 1B, the bulk acoustic resonator has a substrate P100; an acoustic mirror structure P200 is embedded in the substrate or is located on the surface of the substrate, and the specific structure of the acoustic mirror P200 can include a hollow cavity or a Bragg reflecting layer or other equivalent structures that can reflect acoustic waves; a bottom electrode P300 covers the acoustic mirror structure and a part of the substrate; a piezoelectric film layer P400 covers the bottom electrode and a part of the substrate; and a top electrode P500 is located on the piezoelectric layer and covers a part of the piezoelectric layer. The lateral overlapping part of the top electrode P500, the piezoelectric layer P400, the bottom electrode P300 and the hollow cavity P200 defines an effective acoustic region (abbreviated as an effective region) AR of the bulk acoustic resonator. Generally, the bottom electrode P300 and the top electrode P500 further have electrode pins P301 and P501 as shown in Fig. 1A (not shown in Fig. 1B), respectively. In addition, a process adjustment layer that usually covers the surfaces of the functional layers of the resonator such as P500 and P400 is omitted in Fig. 1A and Fig. IB. This type of process layers usually functions to protect the resonator from being eroded by external water vapor and oxygen, or to adjust the performance parameters (such as frequency) of the resonator.

The requirement for the miniaturization of radio frequency filters has led to smaller and smaller chip areas. However, in the prior art, the area of a functional region of a device on the chip is basically unchanged, and it also occupies most of the area of the chip. This directly results in that the area beyond the functional region on the chip becomes smaller when the filter is becoming smaller and smaller, thereby forcing the sizes of a pad and a through hole beyond the functional region to be reduced. The smaller the sizes of the pad and the through hole are, the greater the electrical impedance is, which will affect the insertion loss and the heat dissipation of the filter, resulting in a reduction in the power capacity of the filter. It has become increasingly difficult to reduce the area of the chip by reducing the area beyond the functional region.

In reality, there is a need to further effectively reduce the area of the chip.

**Summary of the Invention**

In order to alleviate or solve at least one aspect of the above-mentioned problems in the use of the prior art, the present disclosure is proposed.

According to one aspect of an embodiment of the present disclosure, a method for reducing the area of an effective region of a bulk acoustic resonator is proposed. The impedance value of the resonator is predetermined, the resonator has a sandwich structure composed of a bottom electrode, a piezoelectric layer and a top electrode, and the method includes the step of doping elements in the piezoelectric layer corresponding to the effective region to reduce the area of the effective region.

According to another aspect of the embodiment of the present disclosure, a bulk acoustic resonator with a predetermined impedance value is proposed, including a sandwich structure composed of a bottom electrode, a piezoelectric layer and a top electrode, wherein the piezoelectric layer is doped with elements; and the area of an effective region of the resonator is smaller than the area of the effective region of a reference resonator, and the reference resonator is a resonator, which has the same structure as the resonator, has the predetermined impedance value, has the same frequency and effective electromechanical coupling coefficient as the resonator, and the piezoelectric layer of which is not doped with elements. Further optionally, the area of the effective region of the resonator is not greater than 80% of the area of the effective region of the reference resonator, further, the area of the effective region of the resonator is not less than 15% of the area of the effective region of the reference resonator, and further, not less than 25%. Optionally, the Q value of the resonator is greater than 1000.

According to still another aspect of the embodiment of the present disclosure, a filter unit is proposed, including: a functional substrate; a packaging substrate opposed to the functional substrate; a functional device disposed on the functional substrate, the functional device includes a plurality of bulk acoustic resonators, each bulk acoustic resonator has a sandwich structure composed of a bottom electrode, a piezoelectric layer and a top electrode, wherein the sum of the areas of the effective regions of all resonators is not greater than 2/3 of the area of one surface of the functional substrate, and further, 1/2.

Optionally, the piezoelectric layer is doped with one or more of the following elements: scandium, yttrium, magnesium, titanium, lanthanum, cerium, praseodymium, neodymium, promethium, samarium, europium, gadolinium, terbium, dysprosium, holmium, erbium, thulium, ytterbium and lutetium.

Optionally, the atomic fraction of the doped element ranges from 1% to 40%. Further optionally, the atomic fraction of the doped element ranges from 3% to 20%.

Optionally, the piezoelectric layer is an aluminum nitride piezoelectric layer, a zinc oxide piezoelectric layer, a lithium niobate piezoelectric layer, or a lead zirconate titanate piezoelectric layer.

The embodiment of the present disclosure further relates to a filter, including: the above-mentioned filter unit or the above-mentioned resonator.

The embodiment of the present disclosure further relates to electronic equipment, including the above-mentioned resonator or the above-mentioned filter.

**Brief Description of the Drawings**

The following description and drawings can better help understand these and other features and advantages in various embodiments disclosed in the present disclosure. The same reference signs in the figures always indicate the same components, wherein:

Fig. 1a is a schematic top view of a bulk acoustic resonator in the prior art;
Fig. 1b is a schematic section view taken along the line AOA' in Fig. 1a;
Fig. 2 is a schematic diagram of a sandwich structure of the bulk acoustic resonator;
Fig. 3 is a curve chart showing the relationship between an electromechanical coupling coefficient Nkt and a ratio r of the bulk acoustic resonator;
Fig. 4a is a schematic top view showing the dissipation of acoustic wave energy from an effective region when the bulk acoustic resonator is working;
Fig. 4b is a schematic section view showing the dissipation of acoustic wave energy from the effective region when the bulk acoustic resonator is working;
Fig. 5 is a schematic top view showing the reduction of the area of the effective region of the bulk acoustic resonator; and
Fig. 6 is a diagram showing the relationship among a doping atomic ratio (atomic fraction), the area of the effective region of the resonator and a perimeter area ratio according to an exemplary embodiment of the present disclosure.

**Detailed Description of the Embodiments**

The technical solutions of the present disclosure will be further described below in detail through the embodiments and in conjunction with the drawings. In the specification, the same or similar reference signs indicate the same or similar components. The following description of the embodiments of the present disclosure with reference to the drawings is intended to explain the general inventive concept of the present disclosure, and should not be construed as a limitation to the present disclosure.

The present disclosure will be exemplarily described below with reference to the drawings.

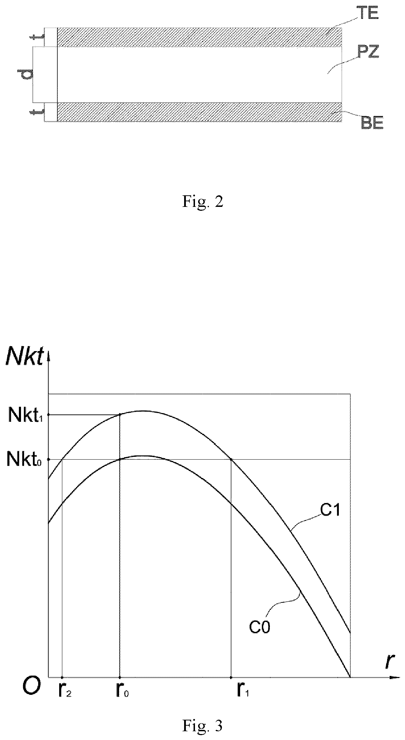

During the working process of a bulk acoustic resonator, the mutual conversion process of electrical energy and mechanical energy mainly occurs in an effective acoustic region AR shown in Fig. 1b. Now, an acoustic stack (this stack is also called a sandwich structure) composed of a bottom electrode, a piezoelectric layer and a top electrode in this region is cut out and is shown enlarged in Fig. 2.

An electromechanical coupling coefficient (Nkt) is one of the important performance indicators of the bulk acoustic resonator. The performance parameter is closely related to the following factors: (1) the ratio of impurity elements doped in a piezoelectric film; and (2) the thickness ratio of an electrode layer to the piezoelectric layer in the sandwich structure.

The sandwich structure of the bulk acoustic resonator shown in Fig. 2 includes a top electrode TE with a thickness t, a bottom electrode BE, and a piezoelectric layer PZ with a thickness d. The ratio is defined here as:

$$r = \frac{2t}{2t+d} \qquad (1)$$

for a particular undoped resonator, the relationship between the normalized electromechanical coupling coefficient Nkt and the ratio r can be described by a characteristic curve C0 shown in FIG. 3.

As shown in Fig. 3, when the piezoelectric layer of the resonator is doped, the characteristic curve C0 moves upward to form a curve C1. If the electromechanical coupling coefficient of the resonator with a thickness ratio $r_0$ before doping is Nkto, then the coefficient is increased to Nkti after doping.

Generally, the electromechanical coupling coefficient is limited by the technical indicators of the relative bandwidth and roll-off characteristics of the filter and needs to remain unchanged. Therefore, in the case of doping, the electromechanical coupling coefficient needs to be restored to the undoped level by adjusting the ratio r. It should be noted that the curve C1 has a maximum value, so there are two ways to adjust the ratio r, that is, reducing the ratio r from $r_0$ to $r_2$ or increasing to $r_1$. However, since the reduction of r means that the electrode layer becomes thinner and the impedance increases, the loss of the device increases. Therefore, as a choice, the ratio r is increased to $r_1$.

On the other hand, the frequency f of the resonator is restricted by the technical indicator of the center frequency of the filter and needs to remain unchanged. The frequency f has the following simplified relationship with the overall thickness of the sandwich structure:

$$f = \frac{v_1}{2D} \qquad (2)$$

wherein D represents the equivalent total thickness of an electrode material (Mo) that is equivalent to a piezoelectric material, specifically $D = 2tv_1/v_2 + d$, wherein $v_2$ represents the longitudinal wave sound velocity in the electrode material, and $v_1$ represents the longitudinal wave sound velocity in the piezoelectric material. Formula (1) is substituted into formula (2) to obtain:

$$f = \frac{v_2}{2d(\frac{r}{1-r}+\frac{v_2}{v_1})} \qquad (3)$$

as the sound velocity $v_1$ is decreased caused by doping and r is increased at the same time, if it is required that the frequency f does not change, then the thickness d of the piezoelectric layer should be reduced.

In addition, there is also a technical requirement for the impedance of the resonator (50 ohms), and the impedance Z and the thickness d of the piezoelectric layer are related by the following formula:

$$Z = \frac{d}{j2\pi f\varepsilon A} \qquad (4)$$

wherein $\varepsilon$ represents the dielectric constant of the piezoelectric material, A represents the effective area of the resonator, and j represents the imaginary unit of the phase.

When the impedance Z is required to be constant, if the thickness d of the piezoelectric layer becomes smaller, the effective area A must also become smaller.

Based on the above description, the thickness d of the piezoelectric layer can be reduced by adding impurity elements into the piezoelectric layer, thereby reducing the effective area A of the resonator.

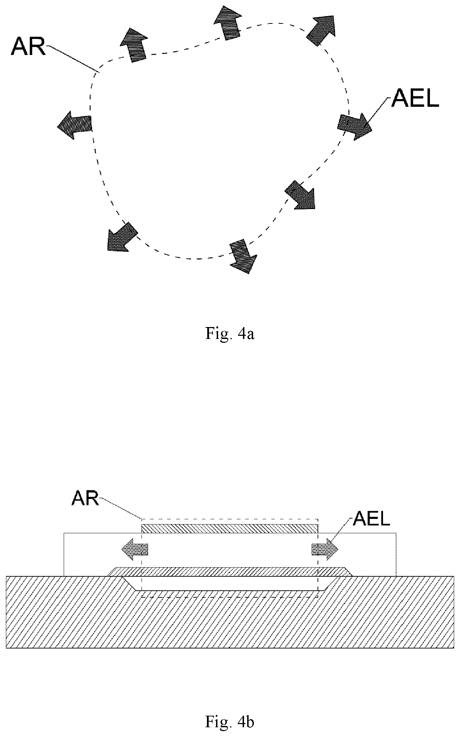

The reduction of the effective area of the resonator can bring many benefits to related structural performance of the resonator, but the reduction of the area is not infinite. This is because when the resonator is working, the acoustic wave energy will inevitably escape from the boundary of the effective region AR shown in Fig. 4a (top view) and Fig. 4b (section view) through acoustic wave energy flow AEL.

For a resonator in which the area of the effective region is A, the perimeter of the effective region is C and the thickness of the effective region is D, if the energy density in the resonator is $\alpha$, then the energy E contained in the resonator is:

$$E=\alpha AD$$

if the energy loss density on the sidewall of the effective region is $\beta$, then the escaped energy E' is:

$$E'=\beta CD$$

if E'/E is defined as the energy loss rate $\eta$, then:

$$\eta = \frac{E'}{E} = \frac{\beta C}{\alpha A} = \lambda R$$

wherein $\lambda = \frac{\beta}{\alpha}$, and the perimeter area ratio is $R = \frac{C}{A}$. Generally speaking, it can be considered that $\lambda$ has nothing to do with the size, and then the energy loss rate $\eta$ is only directly proportional to the perimeter area ratio R.

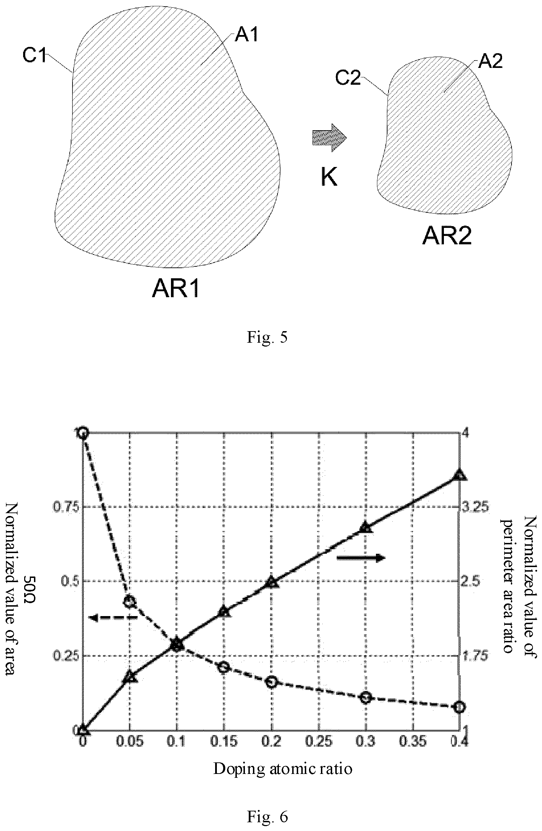

As shown in Fig. 5, for a top view AR1 of the effective region of a resonator with an arbitrary shape (the area is A1, and the perimeter is CI), when its area is similarly reduced as shown in Fig. 5 (the area reduction coefficient is K) to AR2 (the area is A2, and the perimeter is C2), the relationship between the area A1 of AR1 and the area A2 of AR2 is as follows:

$$A2=K\times A1$$

the perimeter area ratios R1 and R2 of AR1 and AR2 are respectively:

$$R1 = \frac{C1}{A1}$$

$$R2 = \frac{C2}{A2}$$

the ratio R1 of the perimeter to the area of AR1 has the following relationship with the ratio R2 corresponding to AR2

$$R2 = \frac{1}{\sqrt{K}} R1$$

wherein, since K is between 0 and 1, it can be seen that the ratio of the perimeter to the area increases as the area decreases. It can be seen that when the shape is unchanged, the smaller the area is, the higher the energy loss rate in the effective region of the resonator is. An excessive small area of the resonator causes excessively high proportion of energy loss, resulting in a serious decline in performance.

Therefore, the area of the effective region of the resonator can be reduced by doping elements, but the energy loss rate needs to be considered at the same time.

Based on the above description, the present disclosure proposes a method for reducing the area of an effective region of a bulk acoustic resonator. The impedance value of the resonator is predetermined, the resonator has a sandwich structure composed of a bottom electrode, a piezoelectric layer and a top electrode, and the method includes the step of doping elements in the piezoelectric layer corresponding to the effective region to reduce the area of the effective region.

Based on the above formula (4), it can be seen that when the impedance Z is required to be constant, if the thickness d of the piezoelectric layer becomes smaller, the effective area A must also become smaller. In other words, by reducing the thickness of the piezoelectric layer, the area of the effective region can be reduced while keeping the impedance of the resonator unchanged.

Optionally, the Q value of the resonator is greater than 1000.

The present disclosure further proposes a bulk acoustic resonator with a predetermined impedance value, including a sandwich structure composed of a bottom electrode, a piezoelectric layer and a top electrode, wherein the piezoelectric layer is doped with elements; and the area of the effective region of the resonator is smaller than the area of the effective region of a reference resonator, and the reference resonator is a resonator, which has the same structure as the resonator, has the predetermined impedance value, and the piezoelectric layer of which is not doped with elements.

The reference resonator here has the same structure as the resonator, which means that except for the reduction in the thickness of the piezoelectric layer or the area of the effective region due to element doping, there is no difference in other factors that affect the impedance value. Specifically, the reference resonator is a resonator, which has the same structure as the resonator, has the predetermined impedance value, has the same frequency and effective electromechanical coupling coefficient as the resonator, and the piezoelectric layer of which is not doped with elements.

In an optional embodiment, the area of the effective region of the resonator is not greater than 80% of the area of the effective region of the reference resonator.

Further, considering the energy loss rate of the effective region of the resonator, the area of the effective region of the resonator is not less than 15% of the area of the effective region of the reference resonator, and further, not less than 25%.

In view of the fact that the functional region of a bulk acoustic wave filter is mainly provided with a plurality of bulk acoustic resonators, after the bulk acoustic resonator adopts the above method to reduce the area of the effective region of the bulk acoustic resonator, the area of the functional region of the bulk acoustic resonator can be effectively reduced. Based on this, the present disclosure further proposes a filter unit, including: a functional substrate (such as the substrate P100 in Fig. 1b); a packaging substrate (not shown) opposed to the functional substrate; and a functional device disposed on the functional substrate, the functional device includes a plurality of bulk acoustic resonators, each bulk acoustic resonator has a sandwich structure (for example, as shown in Fig. 2) composed of a bottom electrode, a piezoelectric layer and a top electrode, wherein the sum of the areas of the effective regions of all resonators is not greater than 2/3 of the area of one surface of the functional substrate, and further, 1/2. It should be pointed out that the area of the surface of the functional substrate here is the entire area of one surface (including the area where the through hole and the functional device are located).

In the embodiment, the piezoelectric layer is doped with one or more of the following elements: scandium, yttrium, magnesium, titanium, lanthanum, cerium, praseodymium, neodymium, promethium, samarium, europium, gadolinium, terbium, dysprosium, holmium, erbium, thulium, ytterbium and lutetium.

Referring to Fig. 6, the atomic fraction (or atomic ratio) of the doped element ranges from 1% to 40%. Within this range, with the increase of the atomic fraction, the area of the resonator is decreased and the perimeter area ratio is increased. Referring to Fig. 6, it can be seen that when the doping ratio is greater than or equal to 20%, the area reduction trend has tended to be flat, but the curve growth trend of the perimeter area ratio is still obvious, so further, the range of the doping ratio is controlled to 3%-20%. The specific atomic fraction can be 1%, 3%, 6%, 20%, 30%, 40%, etc.

The piezoelectric layer can be an aluminum nitride piezoelectric layer, a zinc oxide piezoelectric layer, a lithium niobate piezoelectric layer, or a lead zirconate titanate piezoelectric layer.

In the present disclosure, the material of the top electrode and the bottom electrode can be selected from, but not limited to: molybdenum, ruthenium, gold, aluminum, magnesium, tungsten, copper, titanium, iridium, osmium, chromium or the like or a combination of the above metals or their alloys.

Correspondingly, the present disclosure further relates to a filter, including the above-mentioned filter unit.

The present disclosure further relates to electronic equipment, including the above-mentioned filter unit or filter or functional substrate. It should be pointed out that the electronic equipment here includes, but not limited to, intermediate products such as radio frequency front ends and filter amplification modules, and terminal products such as mobile phones, WIFI, and unmanned aerial vehicles.

Although the embodiments of the present disclosure have been shown and described, for those of ordinary skill in the art, it can be understood that these embodiments can be changed without departing from the principle and spirit of the present disclosure, and the scope of the present disclosure is defined by the appended claims and their equivalents.

**Claims**

1. A method for reducing the area of an effective region of a bulk acoustic resonator, wherein the impedance value of the resonator is predetermined, the resonator has a sandwich structure composed of a bottom electrode, a piezoelectric layer and a top electrode, and the method comprises the step of:
   doping elements in the piezoelectric layer corresponding to the effective region to reduce the area of the effective region.

2. The method according to claim 1, wherein:

the piezoelectric layer is doped with one or more of the following elements: scandium, yttrium, magnesium, titanium, lanthanum, cerium, praseodymium, neodymium, promethium, samarium, europium, gadolinium, terbium, dysprosium, holmium, erbium, thulium, ytterbium and lutetium.

3. The method according to claim 2, wherein:
the atomic fraction of the doped element ranges from 1% to 40%.

4. The method according to claim 3, wherein:
the atomic fraction of the doped element ranges from 3% to 20%.

5. The method according to any one of claims 1-4, wherein:
the piezoelectric layer is an aluminum nitride piezoelectric layer, a zinc oxide piezoelectric layer, a lithium niobate piezoelectric layer, or a lead zirconate titanate piezoelectric layer.

6. A bulk acoustic resonator with a predetermined impedance value, comprising a sandwich structure composed of a bottom electrode, a piezoelectric layer and a top electrode, wherein:

the piezoelectric layer is doped with elements; and
the area of an effective region of the resonator is smaller than the area of an effective region of a reference resonator, and the reference resonator is a resonator, which has the same structure as the resonator, has the predetermined impedance value, has the same frequency and effective electromechanical coupling coefficient as the resonator, and the piezoelectric layer of which is not doped with elements.

7. The resonator according to claim 6, wherein:
the area of the effective region of the resonator is not greater than 80% of the area of the effective region of the reference resonator.

8. The resonator according to claim 7, wherein:
the area of the effective region of the resonator is not less than 15% of the area of the effective region of the reference resonator.

9. The resonator according to claim 8, wherein:
the area of the effective region of the resonator is not less than 25% of the area of the effective region of the reference resonator.

10. The resonator according to claim 6, wherein:
the piezoelectric layer is doped with one or more of the following elements: scandium, yttrium, magnesium, titanium, lanthanum, cerium, praseodymium, neodymium, promethium, samarium, europium, gadolinium, terbium, dysprosium, holmium, erbium, thulium, ytterbium and lutetium.

11. The resonator according to claim 10, wherein:
the atomic fraction of the doped element ranges from 1% to 40%.

12. The resonator according to claim 11, wherein:
the atomic fraction of the doped element ranges from 3% to 20%.

13. The resonator according to claim 6, wherein:
the Q value of the resonator is greater than 1000.

14. The resonator according to any one of claims 6-13, wherein:
the piezoelectric layer is an aluminum nitride piezoelectric layer, a zinc oxide piezoelectric layer, a lithium niobate piezoelectric layer, or a lead zirconate titanate piezoelectric layer.

15. A filter unit, comprising:

a functional substrate;
a packaging substrate opposed to the functional substrate;
a functional device disposed on the functional substrate, the functional device comprises a plurality of bulk acoustic resonators, each bulk acoustic resonator has a sandwich structure composed of a bottom electrode, a piezoelectric layer and a top electrode,

wherein:

the sum of the areas of the effective regions of all resonators is not greater than 2/3 of the area of one surface of the functional substrate.

16. The filter unit according to claim 15, wherein:

the sum of the areas of the effective regions of all resonators is not greater than 1/2 of the area of one surface of the functional substrate.

17. A filter unit, comprising the bulk acoustic resonator according to any one of claims 6-14.

18. The filter unit according to according to any one of claims 15-17, wherein:

the piezoelectric layer is doped with one or more of the following elements: scandium, yttrium, magnesium, titanium, lanthanum, cerium, praseodymium, neodymium, promethium, samarium, europium, gadolinium, terbium, dysprosium, holmium, erbium, thulium, ytterbium and lutetium.

19. The filter unit according to claim 18, wherein:

the atomic fraction of the doped element ranges from 1% to 40%.

20. The filter unit according to claim 19, wherein:

the atomic fraction of the doped element ranges from 3% to 20%.

21. The filter unit according to according to any one of claims 15-20, wherein:

the piezoelectric layer is an aluminum nitride piezoelectric layer, a zinc oxide piezoelectric layer, a lithium niobate piezoelectric layer, or a lead zirconate titanate piezoelectric layer.

22. A filter, comprising:

the filter unit according to according to any one of claims 15-21, or the resonator according to any one of claims 6-14.

23. Electronic equipment, comprising the resonator according to any one of claims 6-14 or the filter according to claim 22.

P501         A         P400

P300

P200

P500

P100

O

A'         P301

Fig. 1a

AR         P500

P400

P300         P100

P200

Fig. 1b

Fig. 2

Fig. 3

Fig. 4a

Fig. 4b

Fig. 5

Fig. 6

## INTERNATIONAL SEARCH REPORT

International application No.

**PCT/CN2019/121083**

**A. CLASSIFICATION OF SUBJECT MATTER**

H03H 9/54(2006.01)i; H03H 9/205(2006.01)i

According to International Patent Classification (IPC) or to both national classification and IPC

**B. FIELDS SEARCHED**

Minimum documentation searched (classification system followed by classification symbols)

H03H

Documentation searched other than minimum documentation to the extent that such documents are included in the fields searched

Electronic data base consulted during the international search (name of data base and, where practicable, search terms used)

CNABS; CNTXT; VEN; EPTXT; USTXT; WOTXT; IEEE; CNKI: 体声波, 谐振器, 滤波器, 电极, 压电, 阻抗, 有效面积, 有效区域, 稀土, 元素, bulk, acoustic, filter, resonator, electrode, piezoelectric, rare, earth

**C. DOCUMENTS CONSIDERED TO BE RELEVANT**

| Category* | Citation of document, with indication, where appropriate, of the relevant passages | Relevant to claim No. |
|---|---|---|
| X | CN 104883153 A (AVAGO TECHNOLOGIES GENERAL IP (SIGAPORE) PTE. LTD.) 02 September 2015 (2015-09-02)<br>    description, paragraphs [0019]-[0068], and figures 1A-6B | 1-23 |
| X | CN 108736857 A (SAMSUNG ELECTRO-MECHANICS CO., LTD.) 02 November 2018 (2018-11-02)<br>    description, paragraphs [0043]-[0093], and figures 1-11 | 1-23 |
| A | CN 1864328 A (KONINKL PHILIPS ELECTRONICS N. V.) 15 November 2006 (2006-11-15)<br>    entire document | 1-23 |
| A | US 6424237 B1 (AGILENT TECHNOLOGIES INC.) 23 July 2002 (2002-07-23)<br>    entire document | 1-23 |

☐ Further documents are listed in the continuation of Box C.   ☑ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| **17 January 2020** | **03 February 2020** |

| Name and mailing address of the ISA/CN | Authorized officer |
|---|---|
| **China National Intellectual Property Administration<br>No. 6, Xitucheng Road, Jimenqiao Haidian District, Beijing 100088<br>China** | |
| Facsimile No. **(86-10)62019451** | Telephone No. |

Form PCT/ISA/210 (second sheet) (January 2015)

**INTERNATIONAL SEARCH REPORT**
Information on patent family members

International application No.

**PCT/CN2019/121083**

| Patent document cited in search report | | | Publication date (day/month/year) | Patent family member(s) | | | Publication date (day/month/year) |
|---|---|---|---|---|---|---|---|
| CN | 104883153 | A | 02 September 2015 | US | 2015244347 | A1 | 27 August 2015 |
| | | | | CN | 104883153 | B | 05 June 2018 |
| | | | | US | 9455681 | B2 | 27 September 2016 |
| | | | | KR | 20150101959 | A | 04 September 2015 |
| | | | | JP | 2015162905 | A | 07 September 2015 |
| CN | 108736857 | A | 02 November 2018 | US | 2018309427 | A1 | 25 October 2018 |
| | | | | KR | 20180117466 | A | 29 October 2018 |
| CN | 1864328 | A | 15 November 2006 | KR | 20060120007 | A | 24 November 2006 |
| | | | | JP | 4719683 | B2 | 06 July 2011 |
| | | | | AT | 449457 | T | 15 December 2009 |
| | | | | CN | 100492902 | C | 27 May 2009 |
| | | | | KR | 101323447 | B1 | 29 October 2013 |
| | | | | EP | 1673860 | B1 | 18 November 2009 |
| | | | | JP | 2007507958 | A | 29 March 2007 |
| | | | | US | 7474174 | B2 | 06 January 2009 |
| | | | | US | 2007120624 | A1 | 31 May 2007 |
| | | | | DE | 602004024224 | D1 | 31 December 2009 |
| | | | | WO | 2005034349 | A1 | 14 April 2005 |
| | | | | EP | 1673860 | A1 | 28 June 2006 |
| US | 6424237 | B1 | 23 July 2002 | KR | 100806504 | B1 | 21 February 2008 |
| | | | | EP | 1217734 | A3 | 27 August 2008 |
| | | | | EP | 1217734 | A2 | 26 June 2002 |
| | | | | US | 2002079986 | A1 | 27 June 2002 |
| | | | | MY | 119892 | A | 29 July 2005 |
| | | | | KR | 20020050729 | A | 27 June 2002 |
| | | | | JP | 2002223144 | A | 09 August 2002 |
| | | | | SG | 98460 | A1 | 19 September 2003 |

Form PCT/ISA/210 (patent family annex) (January 2015)